## Europäisches Patentamt

## European Patent Office

## Office européen des brevets

(19)

(11) **EP 0 740 139 B1**

(12) **EUROPÄISCHE PATENTSCHRIFT**

(45) Veröffentlichungstag und Bekanntmachung des Hinweises auf die Patenterteilung:
**27.01.1999 Patentblatt 1999/04**

(51) Int Cl.⁶: **G01L 5/00**, G01L 1/24, C23C 14/54

(21) Anmeldenummer: **96250096.3**

(22) Anmeldetag: **25.04.1996**

(54) **Vorrichtung zur in-situ Messung von mechanischen Spannungen in Schichten**

Device for in situ measurement of stress in films

Dispositif pour la mesure in situ des contraintes mécaniques dans des couches

(84) Benannte Vertragsstaaten:
**CH FR GB LI NL SE**

(30) Priorität: **26.04.1995 DE 19516256**

(43) Veröffentlichungstag der Anmeldung:
**30.10.1996 Patentblatt 1996/44**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
- **Lüthje, Holger Dipl.-Ing.**
  **25469 Halstenbek (DE)**
- **Daaud, Simone Dipl.-Ing.**
  **38122 Braunschweig (DE)**

(74) Vertreter: **Pfenning, Meinig & Partner**
**Kurfürstendamm 170**
**10707 Berlin (DE)**

(56) Entgegenhaltungen:
EP-A- 0 497 499    WO-A-95/31706
JP-A-62 260 078

**Beschreibung**

Die Erfindung betrifft eine Vorrichtung zur in-situ Messung von mechanischen Spannungen in Schichten nach dem Oberbegriff des Hauptanspruchs.

Es ist bekannt, daß sich bei der Herstellung von Schichten auf einer Unterlage mittels PVD- oder CVD-Techniken unterschiedliche intrinsische und thermische Spannungen in der Schicht ausbilden. Während der thermische Streßanteil im wesentlichen durch die unterschiedlichen Ausdehnungen der Materialien verursacht wird, sind die inneren Spannungen in einer Schicht oder einem Schichtsystem in komplexer Weise von dem Schichtmaterial und den Beschichtungsbedingungen abhängig. Der Streß in den Schichten ist in der Praxis häufig Ursache für das Schichtversagen, indem die Schicht unter der Streßbeanspruchung von der Unterlage lokal oder großflächig delaminiert. Je nach Anwendung treten verschiedene streßbedingte Schäden auf, die sich beispielsweise durch Mikrorisse, Substratdeformationen und Schicht-Buckling beschreiben lassen und die Funktion der Schicht mindern oder vollständig zerstören.

Im Bereich der harten und superharten Schichten, die derzeit mit großem Erfolg für z.B. verschiedene tribologische Anwendungen eingesetzt werden, kommt dem Streß in den Schichten oder Schichtsystemen eine besondere Bedeutung zu, da die Herstellungsverfahren zur Erzielung hoher Härtegrade in den Schichten häufig zu einer sehr hohen Schichtspannung führen. Um diese Schichten mit ausreichender Haftung auf die gewünschten Substrate aufzubringen, bedarf es einer intensiven Vorbehandlung der Substratoberflächen und der Anwendung von Zwischen- und/oder Gradientenschichten. Eine während der Beschichtung kontinuierlich durchgeführte Streßkontrolle würde eine streßoptimierte Prozeßführung sowie ein neuartiges StreßEngineering ermöglichen.

Zur Ermittlung von mechanischen Spannungen in dünnen Schichten werden im wesentlichen drei Methoden angewandt, die allerdings nur ex-situ Messungen erlauben:

1) Röntgendiffraktrometrische Messungen an Schichten auf geeigneten Substraten und Berechnung der inneren Spannungen anhand der Peaklagen. Eingeschränkte Substratauswah, da häufig Peak-Überlagerungen von Substrat- und Schichtmaterial zu berücksichtigen sind. Die Methode ist sehr aufwendig.

2) Streßbestimmung unter Verwendung von Membran-Substraten, die mit der zu messenden Schicht belegt werden müssen. Die Streßermittlung erfolgt im wesentlichen auf zwei Weisen, nämlich durch akustische Anregungen (Vibrationstechniken) oder durch Anwendung einer Druckdifferenz auf die Membran und Messung der Auslenkung in Abhängigkeit vom Druck (Bulge-Messung).

3) Auswertung einer durch die Schicht verursachten Substratverformung mit Hilfe von Abstandsmessungen. Angewandt wurden kapazitive Abstandsermittlungen, optische Verfahren (Interferenz, Triangulation) und (induktive bzw. piezoresistive) mechanische Abtastverfahren.

Bei diesen Methoden muß das Substrat hinsichtlich Elastizitätsmodul und Dicke an die zu messende Schichtspannung angepaßt sein. Eine Vereinfachung in der Auswertung kann durch eine deutlich anisotrop ausgeprägte Substratgeometrie (Länge/Breite > 7) erreicht werden. In der Praxis haben sich daher sowohl Glasstreifen als auch streifenförmige Substrate aus Stahl und Silicium durchgesetzt.

Diese Methoden haben den erheblichen Nachteil, daß damit nicht der wachstumsspezifische Streß in den Schichten (der Streß in den einzelnen Wachstumsphasen kann sehr unterschiedlich sein) ermittelt werden kann, sondern nur der integrale Wert.

Die Auswertung kann in diesem Fall mit Hilfe folgender Beziehung vorgenommen werden. Dabei ist zu bedenken, daß der gemessene Streß sich aus einem thermischen (t) und einem intrinsischen (i) Anteil zusammensetzt.

$$\sigma_{i+t} = \{4\,E_s t_s^{\,2}/3(1\text{-}v)L^2\}\;\delta/d_f$$

| | |
|---|---|
| Totaler Streß | $\sigma_{i+t}$ |
| Substratdicke | $t_s$ |
| Substrat länge | $L$ |
| Schichtdicke | $d_f$ |
| E-Modul Substrat | $E_s$ |
| Poissonzahl | $v$ |
| Substratdurchbiegung | $\delta$ |

Der thermische Anteil resultiert aus der Differenz der thermischen Ausdehnungskoeffizienten von Schicht und Substrat und kann mit Hilfe folgender Beziehung abgeschätzt werden.

$$\sigma_{th} = E_f(\alpha_f - \alpha_s)(T_s - T_a)$$

| Thermischer Streß | $\sigma_{th}$ |
| Ausdehnungskoeffizient des Substrats bzw. der Schicht | $\alpha_s, \alpha_f$ |
| E-Modul der Schicht | $E_f$ |
| Temperatur des Substrats während der Beschichtung | $T_s$ |
| Umgebungstemperatur nach Abkühlung des Substrats | $T_a$ |

In-situ Streßmessungen an dünnen Schichten sind bisher nur in experimentellen Beschichtungsanlagen durchgeführt worden, indem beispielsweise die Durchbiegung von Silicium-Wafern als Folge der Beschichtung mit Hilfe eines an der Schichtoberseite reflektierten Lichtstrahls (Laser) ermittelt und der Streß errechnet wurde. Die Anwendung der bekannten Verfahren zur Bestimmung der mechanischen Spannungen während der Beschichtung sind jedoch nur in speziellen Anlagen anwendbar und nicht auf industrielle Beschichtungsanlagen übertragbar, da bei diesen die Substrate zur Erzielung einer gleichmäßigen Beschichtung bewegt werden müssen (Mehrfachrotationen, Durchlaufanlagen) oder sich in einer nicht zugänglichen Umgebung (geschlossenen Beschichtungskammern) befinden.

Weiterhin sind experimentelle in-situ Untersuchungen bekannt, in welchen rückseitig Durchbiegungen von Glas- und Polyamidsubstraten während einer Beschichtung ermittelt wurden (In situ measurements of film stress in AIN sputtered onto moving substrates, B.C. Bell, D.A. Glocker; J. Vac. Sci. Technol. A, Vol.9 No. 4, Jul/Aug 1991, S. 2437 - 2441). Der Nachteil dieser Experimente lag jedoch darin, daß nicht bei hohen Temperaturen gearbeitet werden konnte und zudem ein Betrieb mit angelegter Biasspannung nicht möglich war. Die Biasspannung ist in bezug auf die Schichtspannung jedoch ein wesentlicher Parameter, welcher keinesfalls unberücksichtigt bleiben sollte.

Die bekannten Verfahren zur in-situ Bestimmung der mechanischen Spannungen in dünnen Schichten besitzen essentielle Nachteile, da die Substrate während der Messung nicht bewegt werden dürfen und über ein Vakuumfenster eine direkte Beobachtung der Oberfläche, mit z.B. einem Laserstrahl, ermöglich werden muß. Eine solche Anordnung hat darüber hinaus den Nachteil, daß durch die Beschichtung auch das Vakuumfenster beschichtet wird, was zu Meßfehlern und Streuungen der Meßsignale führen kann. Außerdem wird die Oberfläche der Probe durch die Schicht hinsichtlich Reflektivität und Topografie verändert, was wiederum die Meßgenauigkeit nachteilig beeinflussen kann. Neben einem großen Kalibrationsaufwand vor jeder Messung, weist die Methode auch den Nachteil auf, daß das Substrat nur unpräzise hinsichtlich der Lage relativ zum Meßpunkt eingebaut werden kann und daß der Ort maximaler Auslenkung der Probe nicht exakt mit dem Laserstrahl getroffen wird.

Aufgabe der vorliegenden Erfindung ist es, eine Vorrichtung zur in-situ Messung von mechanischen Spannungen in Schichten vorzuschlagen, die eine Messung der Spannungen während der Schichtentstehung ermöglicht und mit der reale Situationen in industriellen Anlagen meßtechnisch kontrolliert werden können, wobei sie flexibel in verschiedenen Vakuum-Beschichtungsanlagen einsetzbar sein soll.

Diese Aufgabe wird erfindungsgemäß durch die kennzeichnenden Merkmale des Hauptanspruchs in Verbindung mit den Merkmalen des Oberbegriffs gelöst.

Dadurch, daß ein äußeres und ein inneres Gehäuse vorgesehen sind, wobei an dem äußeren Gehäuse die Halterung für das Meßsubstrat, die in Bezug auf das Substrat starr ist, und in dem inneren Gehäuse die wesentlichen Bauelemente der Abstandsmeßeinrichtung angeordnet sind, und das innere Gehäuse vakuumdicht und elektrisch isoliert ist und mittels eines über Zuleitungen zugeführten Kühlmediums gekühlt wird, ist die Verwendung der erfindungsgemäßen Vorrichtung in jeglicher Art von Beschichtungsanlage und bei beheizten und mit einem elektrischen Potential in einer Gasentladung beaufschlagten Substraten möglich. Die Streßmessung kann auch bei sehr hohen Temperaturen sowie unter Beaufschlagung einer Substratbiasspannung durchgeführt werden. Die Vorrichtung ist mobil und kann über eine Aufhängung auswechselbar in den verschiedensten Beschichtungsanlagen angeordnet werden.

Durch die in den Unteransprüchen angegebenen Maßnahmen sind vorteilhafte Weiterbildungen und Verbesserungen möglich.

Bei Vorsehen von Drehdurchführungen für die Zuleitungen in das innere Gehäuse kann die erfindungsgemäße Vorrichtung auch bei Beschichtungsanlagen mit drehbaren Substrattischen angewandt werden. Mittels einer Regelvorrichtung für den Kühlkreislauf kann der Innenraum des inneren Gehäuses auf bestimmte thermische Verhältnisse stabilisiert werden.

Da die Abstansmessung ander Rückseite des Meßsubstrats durchgeführt wird, können sowohl transparente als auch opake Schichten genau gemessen werden. Unterschiedliche Dicken des Meßsubstrats ermöglichen eine Abstufung der Meßbereiche.

Weiterhin kann die Vorrichtung zur Optimierung von Beschichtungsprozessen sowie zur Regelung von streßgesteuerten Beschichtungsprozessen verwandt werden.

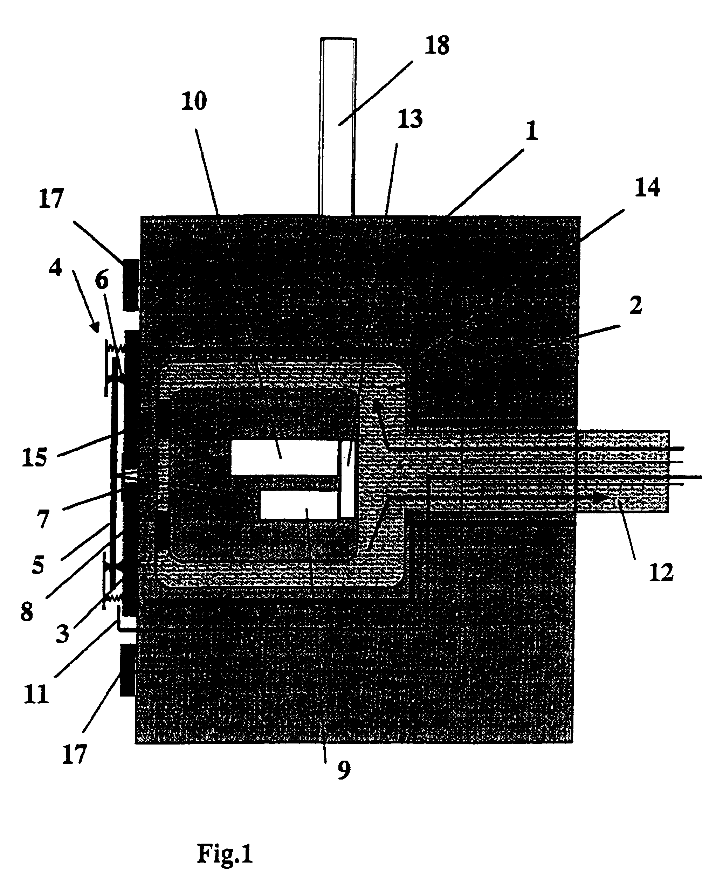

Ein Ausführungsbeispiel der vorliegenden Erfindung ist in der Zeichnung dargestellt und wird in der nachfolgenden Beschreibung näher erläutert. Die einzige Figur zeigt eine schematische Darstellung der erfindungsgemäßen Vorrichtung.

In der Figur ist mit 1 ein äußeres Gehäuse bezeichnet, das zumindest teilweise, z.B. die Vorderseite, aus Materialien hergestellt ist, die eine geringe thermische Ausdehnung besitzen, z.B. Molybdän, Quarzglas, Keramik, und die mit einer höheren Temperatur beaufschlagt werden können. In dem äußeren Gehäuse 1 ist ein inneres Gehäuse 2 aufgenommen, das hochvakuumdicht ausgeführt ist und aus einem elektrisch leitenden Material, z.B. Edelstahl oder Aluminium oder dergleichen, besteht. Das innere Gehäuse 2 ist mit dem äußeren Gehäuse 1 über Halterungen 3 verbunden, die aus nichtleitendem Material bestehen und einen geringen Wärmeausdehnungskoeffizienten bzw. eine geringe Wärmeleitfähigkeit aufweisen. Um das innere Gehäuse herum ist eine Abschirmung 14 mit geringem Abstand angeordnet, der so bemessen ist, daß er sehr viel kleiner ist als der Dunkelraumabstand, wodurch das Auftreten von Stoßionisationen in dem Raum zwischen dem auf Erdpotential liegenden inneren Gehäuse 2 und der Abschirmung weitgehend vermieden wird.

An dem äußeren Gehäuse 1 ist eine Platte 15 mit geringer Wärmeausdehnung z.B. Keramik angeordnet und fest mit ihm verbunden, an der eine Aufnahmevorrichtung 4 für Spannungsmeßsubstrate 5 befestigt, die streifenartig ausgebildet sind und z.B. aus Silicium oder Metall bestehen. Im dargestellten Ausführungsbeispiel ist der Spannungsmeßstreifen 5 an beiden Enden gehaltert, er kann aber auch nur einseitig gelagert sein. Die Aufnahmevorrichtung 4 besteht aus einer Keillagerung, d.h. an der Oberseite und der Unterseite des Spannungsmeßstreifens 5 sind zwei Keile 6 vorgesehen, von denen der der Unterseite zugewandte und mit der als Wärmesperre dienenden Platte verbundene Keil 6 starr und der der Schicht zugewandte Keil federnd gelagert ist. Für die Aufnahme des Spannungsmeßstreifens 5 wird ein Keil 6 über die Feder weggedrückt, und der Meßstreifen 5 wird anschließend durch die zwei Keile 6 eingeklemmt. Mit Hilfe der Keillagerung und der gefederten keilartigen Klemmung wird erreicht, daß sich der Spannungsmeßstreifen 5 unter der mechanischen Spannung einer darauf aufgebrachten Schicht frei bewegen kann, wobei durch die Platte 15 vermieden wird, daß eine thermische, das Meßergebnis verfälschende Verformung aufgrund eines Wärmeüberganges zwischen innerem und äußerem Gehäuse auftritt. Hinter dem Spannungsmeßstreifen ist ein Fenster 7 in der Vorderseite des äußeren Gehäuses 1 vorgesehen, das mit einem leicht austauschbaren Schutzglas und mit Blenden versehen sein kann, um eine Belegung des Fensters zu verhindern.

Das innere Gehäuse 2 weist gleichfalls ein vakuumdicht verschlossenes Fenster 8 aus einem optisch transparenten Material auf, vor dem gleichfalls ein leicht auswechselbares Schutzglas sowie seitliche Blenden angebracht sein können. In dem inneren Gehäuse 2 ist eine Abstandsmeßeinrichtung angeordnet, die schematisch durch eine Laserstrahlungsquelle 9 und durch eine optoelektronische Empfängeranordnung 10 dargestellt ist. Der von der Laserquelle 9 ausgesandte Laserstrahl wird auf die Rückseite des Spannungsmeßsubstrats 5 über die Fenster 8 und 7 gerichtet und von der Rückseite des Spannungsmeßstreifens 5 auf die Empfängeranordnung 10 reflektiert. Dabei ist der Meßstreifen auf der Rückseite mit einer neutralen Oberfläche, vorzugsweise mit einer dünnen Metallbeschichtung versehen, um Temperatureffekte auszuschließen. Abhängig von der Änderung der Strahlausrichtung kann der Abstand bzw. die Durchbiegung des Spannungsmeßstreifens 5 bestimmt werden. Die Abstandsmeßeinrichtung 9, 10 kann nach dem Triangulationsprinzip aufgebaut sein. Es kann auch ein Laserinterferrometer oder ein Laserscanner oder andere Meßverfahren, wie induktive oder kapazitive Wegmessung oder dgl. verwendet werden. Die Abstandsmeßeinrichtung kann auch als ein Mikrosystem ausgebildet werden.

Zur Bestimmung der Temperatur des Spannungsmeßsubstrats 5 ist eine als Thermoelemente ausgebildete Temperaturmeßvorrichtung 11 vorgesehen, die an dem oder in unmittelbarer Nähe des Substrats 5 angeordnet sind. Die Temperatur kann aber auch mit einem in dem inneren Gehäuse 2 aufgenommenen Pyrometer oder mit einem die IR Strahlung erfassenden Lichtleiter oder dgl. gemessen werden.

Das innere Gehäuse 2 wird mittels eines Kühlmediums gekühlt, das über einen Anschluß bzw. eine Durchführung 12 zugeführt werden kann. Die Kühlung des inneren Gehäuses 2 kann auf unterschiedliche Weise realisiert werden, beispielsweise kann ein Gasstrom, z.B. He, $N_2$, Luft, über die Durchführung 12 in den Innenraum des inneren Gehäuses geleitet werden. Es kann aber auch ein flüssiges Medium, beispielsweise Wasser, verwendet werden, wobei in diesem Fall das innere Gehäuse als Doppelmantel ausgeführt sein kann oder mit Kühlkanälen versehen ist. In dem Innenraum befindet sich ein nicht dargestellter Temperatursensor, der die Innentemperatur erfaßt, und vorzugsweise wird abhängig von der Temperatur der Fluß des Kühlmediums über einen Regelkreis so geregelt, daß der Innenraum des inneren Gehäuses 2 und die entsprechenden Bauelemente 9, 10, 11 auf einer konstanten vorgegebenen Temperatur gehalten werden. Bei konstantem Kühlfluß ist auch die Anwendung einer Kompensationsmethode möglich, wobei eine entsprechende Auswerteschaltung auch in der Lage ist, mit Hilfe von Kalibrationskurven eine Korrektur der thermisch bedingten Abstandsänderungen vorzunehmen und bei der Auswertung der Streßwerte bzw. Spannungswerte entsprechend zu berücksichtigen.

Eine Auswerteschaltung 13, die die von den im Innenraum vorgesehenen Sensoren bzw. Meßvorrichtungen gelieferten Signale auswertet, kann gleichfalls im inneren Gehäuse 2 angeordnet sein. Die notwendigen elektrischen Leitungen und gegebenenfalls optischen Leitungen werden gleichfalls über die Durchführung 12 geführt, wobei jedoch mehrere Durchführungen sowohl im inneren als auch im äußeren Gehäuse 1,2 vorgesehen sein können.

Im Falle von bewegten Proben ist die Durchführung 12 als Drehdurchführung ausgebildet, bei der die elektrischen Anschlüsse über Schleifkontakte und/oder Optokoppler versorgt werden und das Kühlmedium über entsprechende Kanäle zugeführt wird.

Sowohl die Messung der Temperatur des Meßstreifens 5 über die Strahlung als auch die Abstandsmessung kann über optische Fasern erfolgen, die gegebenenfalls auch über die Durchführungen bzw. Drehdurchführungen geleitet werden. Die elektrischen Signale können aus dem inneren Gehäuse 2 auch telemetrisch ausgekoppelt werden.

In der Figur ist ein diskretes Spannungsmeßsubstrat 5 dargestellt. Es können als Meßsubstrat jedoch auch Metallbänder verwendet werden, die mittels einer in dem äußeren Gehäuse 1 angeordneten Aufwickelvorrichtung auf- und abgerollt werden und die es erlauben, ohne Unterbrechung des Beschichtungsprozesses ein neues Meßsubstrat in die Aufnahmevorrichtung 6 einzuspannen.

Das äußere Gehäuse 1 kann je nach Anwendung mit zusätzlichen Sensoren ausgerüstet werden, z.B. Sonden zur Messung des Ionenstroms, optische Sensoren für Schichttransparenz und Temperatur. Im dargestellten Ausführungsbeispiel sind über und unter dem Meßsubstrat 5 Ionenkollektoren 17 an der Vorderseite des äußeren Gehäuses 1 angebracht, mit denen die lokale Ionenstromdichte bestimmt werden kann. Zur in-situ Messung der Schichtdicke kann ein Ratenmonitor im inneren Gehäuse 2 vorgesehen sein. Die Schichtdicke kann auch mit Hilfe der Rate über die Zeit oder durch Absorption bestimmt werden.

Zur Messung von mechanischen Spannungen in Schichten wird die erfindungsgemäße Vorrichtung in die PVD- oder CVD-Beschichtungsanlage eingebracht, wobei eine an dem äußeren Gehäuse 1 befestigte Aufhängung 18 eine Anordnung an gewünschter Stelle ermöglicht, und das Meßsubstrat 5 wird dem Beschichtungsvorgang ausgesetzt. Die Abstandsmeßeinrichtung bestimmt die Durchbiegung des Meßsubstrats 5, und die Schichtdicke wird mit dem Ratenmonitor oder mittels Rate über die Zeit bestimmt. Mit diesen Meßgrößen kann über die Auswerteschaltung 13 oder einen externen Rechner der Gesamtstreß bzw. die Gesamtspannung berechnet werden. Dabei werden die Meßeinrichtungen in dem inneren Gehäuse 2 durch das äußere Gehäuse 1 gegen Beschichtung und Kontamination sowie thermische Belastung und der Einwirkung von elektrischen Entladungen bei Anwendungen der Einrichtung im Bereich von plasmagestützten PVD-Verfahren, insbesondere Sputter-Verfahren geschützt. Wenn notwendig, kann der Spannungsmeßstreifen 5 und das äußere Gehäuse 1 mit einer Substratbiasspannung von mehreren 100 V beaufschlagt werden. Dies kann sowohl mit Gleichspannung als auch Hochfrequenz- und Mittelfrequenzspannungen sowie anderen Potentialen, z.B. bipolaren Pulstechniken, geschehen. Die Vorrichtung kann bei Temperaturen bis zu 900 °C und im Plasma betrieben werden. Bei Batchbeschichtungsanlagen mit drehbarem Substrattisch werden die elektrischen und/oder optischen Leitungen sowie die Zuleitung des Kühlmediums durch die Drehdurchführung geführt.

Der thermische Streß kann entsprechend den oben angegebenen Gleichungen abgeschätzt werden, wobei die mit der Temperaturmeßvorrichtung 11 gemessenen Temperaturwerte sowie die nach der Abkühlung vorhandene Substrattemperatur verwendet wird. Um unterschiedliche Meßbereiche zu realisieren, können Meßsubstrate mit unterschiedlichen Dicken verwendet werden.

Die Vorrichtung kann zur Regelung der Schichtspannung während der Schichtherstellung durch Steuerung bzw. Regelung des Substratbias-, des Targetpotentials und -leistung, des Totaldrucks während des Sputterns der Gaszusammensetzung bei reaktiver Schichtherstellung oder der Kathodenleistung verwendet werden, wodurch Schichten oder Schichtsysteme mit definierter mechanischer Spannung auf Unterlagen abgeschieden werden können. Darüber hinaus kann die Vorrichtung dazu verwendet werden, um Schichten mit bestimmten mechanischen und elektrischen Eigenschaften auf einem Substrat zu erzeugen.

**Patentansprüche**

1. Vorrichtung zur in-situ Messung von mechanischen Spannungen in Schichten, die während der Schichtherstellung in der Beschichtungsanlage angeordnet ist, mit einer Abstandsmeßeinrichtung (9,10) zur Ermittlung der Verformung eines dem Beschichtungsvorgang ausgesetzten Meßsubstrats (5) und einer Temperaturmeßeinrichtung (11) zur Messung der Temperatur des Meßsubstrats,
**dadurch gekennzeichnet ,**
daß ein äußeres Gehäuse (1) vorgesehen ist, an dem die Halterung (4) für das Meßsubstrat (5) angeordnet ist, und daß in dem äußeren Gehäuse (1) ein inneres Gehäuse (2) vakuumdicht aufgenommen ist, das elektrisch zu dem äußeren Gehäuse (1) isoliert ist und mittels eines über Zuleitungen zugeführten Kühlmediums kühlbar ist, wobei zumindest die wesentlichen Bauelemente der Abstandsmeßeinrichtung (9,10) bestehend aus Sender- und Empfängeranordnung im inneren Gehäuse (2) angeordnet sind.

2. Vorrichtung nach Anspruch 1, dadurch gekennzeichnet, daß das innere Gehäuse (2) elektrisch leitendes Material aufweist und auf Erdpotential liegt.

3. Vorrichtung nach Anspruch 1 oder Anspruch 2, dadurch gekennzeichnet, daß im inneren Gehäuse (2) ein Temperatursensor vorgesehen ist und daß ein Regelkreis das Kühlmedium in der Weise regelt, daß im inneren Gehäuse (2) eine vorgegebene Temperatur herrscht.

4. Vorrichtung nach einem der Ansprüche 1 bis 3, dadurch gekennzeichnet, daß die Halterung (4) des Meßsubstrats (5) an einem oder beiden Enden als beidseitig des Substrats angeordnete Keillagerung (6) ausgebildet ist, wobei die mit dem äußeren Gehäuse direkt verbundene Keillagerung starr ist und die der Schichtseite zugewandte Keillagerung federnd ausführbar ist.

5. Vorrichtung nach einem der Ansprüche 1 bis 4, dadurch gekennzeichnet, daß die Abstandsmeßeinrichtung mindestens eine Laserquelle (9) und eine Strahlungsempfängeranordnung (10) aufweist, wobei der von der Laserquelle (9) ausgesandte Laserstrahl auf die Rückseite des Meßsubstrats (5) gerichtet ist und die reflektierte Strahlung von der Empfängeranordnung (10) empfangen wird.

6. Vorrichtung nach einem der Ansprüche 1 bis 5, dadurch gekennzeichnet, daß die Abstandsmeßeinrichtung als Triangulationsmeßeinrichtung oder als Interferometer ausgebildet ist.

7. Vorrichtung nach einem der Ansprüche 1 bis 6, dadurch gekennzeichnet, daß die Temperaturmeßeinrichtung als an oder in unmittelbarer Nähe des Meßsubstrats (5) angeordneter Thermosensor (11) oder als Pyrometer ausgebildet ist, das in dem inneren Gehäuse (2) aufgenommen ist.

8. Vorrichtung nach einem der Ansprüche 1 bis 7, dadurch gekennzeichnet, daß die mit den elektrischen Bauteilen im inneren Gehäuse (2) verbundenen elektrischen Leitungen, die Zuleitungen für das Kühlmedium und gegebenenfalls optische Fasern, die bei der Temperatur- und/oder Abstandsmeßeinrichtung verwendet werden, über mindestens eine vakuumdichte Durchführung in der Wand des inneren Gehäuses geführt sind.

9. Vorrichtung nach Anspruch 8, dadurch gekennzeichnet, daß die Durchführung (12) als Drehdurchführung ausgebildet ist.

10. Vorrichtung nach einem der Ansprüche 1 bis 9, dadurch gekennzeichnet, daß das Spannungsmeßsubstrat (5) auf einer in dem äußeren Gehäuse (1) vorgesehenen Aufwickelvorrichtung angeordnet ist.

11. Vorrichtung nach einem der Ansprüche 1 bis 10, dadurch gekennzeichnet, daß eine Einrichtung zur Bestimmung der Schichtdicke wie ein Ratenmonitor vorgesehen ist.

12. Vorrichtung nach einem der Ansprüche 1 bis 11, dadurch gekennzeichnet, daß das innere Gehäuse (2) mit einer Abschirmung (14) versehen ist, die dieses mit geringem Abstand umgibt.

13. Vorrichtung nach einem der Ansprüche 1 bis 12, dadurch gekennzeichnet, daß an dem Gehäuse zumindest beidseitig des Meßsubstrats (5) jeweils eine Vorrichtung zur Messung des Ionenstroms vorgesehen ist.

14. Vorrichtung nach einem der Ansprüche 1 bis 4 oder 7 bis 13, dadurch gekennzeichnet, daß die Abstandsmeßeinrichtung als kapazitive oder induktive Wegmeßeinrichtung ausgebildet ist.

## Claims

1. Device for in situ measuring of mechanical stress in layers, which is placed during production of a layer in the coating plant, comprising a gap measuring device (9, 10) for determining deformation of a measuring substrate (5) subjected to a coating process and a temperature measuring device (11) for measuring the temperature of the measuring substrate, characterised in that an outer housing (1) is provided on which is placed the support (4) for the measuring substrate (5), and in the outer housing (1) is accommodated in a vacuum tight manner an inner housing (2) which is electrically insulated from the outer housing (1) and cooled by means of a cooling medium which is delivered by means of supply pipes, and at least the essential assembly components of the gap measuring device (9, 10) comprising transmitter and receiver units are arranged inside the housing (2).

2. Device according to Claim 1, characterised in that the inner housing (2) comprises electrically conducting material and lies on ground potential.

EP 0 740 139 B1

**3.** Device according to Claim 1 or Claim 2, characterised in that in the inner housing (2) is provided a temperature sensor and a control circuit regulates the cooling medium in such a manner that a predetermined temperature is established in the inner housing (2).

**4.** Device according to one of Claims 1 to 3, characterised in that the support (4) of the measuring substrate (5) on one or both ends is designed as a wedge mount (6) on both sides of the substrate, and the wedge mount which is directly connected to the outer housing is of rigid design whereas the wedge mount facing towards the coating is of resilient design.

**5.** Device according to one of Claims 1 to 4, characterised in that the gap measuring device comprises at least one laser source (9) and one radiation receiver unit (10), and the laserbeam emitted by the laser source (9) is oriented towards the rear of the measuring substrate (5), and the reflected radiation is received by the receiver unit (10).

**6.** Device according to one of Claims 1 to 5, characterised in that the gap measuring device is designed as a triangulation measuring device or as an interferometer.

**7.** Device according to one of Claims 1 to 6, characterised in that the temperature measuring device is designed as a thermosensor (11) positioned on or in the immediate vicinity of the measuring substrate (5) or as a pyrometer which is accommodated in the inner housing (2).

**8.** Device according to one of Claims 1 to 7, characterised in that the electrical cables which are connected to the electrical components in the inner housing (2), the supply pipes for the cooling medium and, if appropriate, optical fibres used in a temperature and/or gap measuring unit are ducted via at least one vacuum-tight passage in the wall of the inner housing.

**9.** Device according to Claim 8, characterised in that the passage (12) is designed as a rotary passage.

**10.** Device according to one of Claims 1 to 9, characterised in that the stress measuring substrate (5) is arranged on a winding up device provided in the outer housing (1).

**11.** Device according to one of Claims 1 to 10, characterised in that a device for determining the layer thickness, such as a rate monitor, is provided.

**12.** Device according to one of Claims 1 to 11, characterised in that the inner housing (2) is provided with a screen (14) which encapsulates it with a small gap.

**13.** Device according to one of Claims 1 to 12, characterised in that on the housing at least on both sides of the measuring substrate (5) is provided a respective device for measuring the ion flow.

**14.** Device according to one of Claims 1 to 4 or 7 to 13, characterised in that the gap measuring device is designed as a capacitive or inductive path measuring device.

**Revendications**

**1.** Dispositif pour la mesure in-situ des contraintes mécaniques dans des couches, qui est disposé dans l'installation de recouvrement lors de la fabrication des couches, présentant un dispositif de mesure d'espacement (9,10) permettant d'enregistrer la déformation d'un substrat de mesure (5) soumis au processus de recouvrement et un dispositif de mesure de la température (11) permettant de mesurer la température du substrat de mesure, caractérisé en ce qu'il est prévu un boîtier externe (1) contre lequel est disposée la fixation (4) pour le substrat de mesure (5), et en ce que, dans le boîtier externe (1) est logé de façon étanche au vide un boîtier interne (2) qui est isolé électriquement du boîtier externe (1) et peut être refroidi au moyen d'un produit réfrigérant amené par des conduites, au moins les éléments de conception essentiels du dispositif de mesure d'espacement (9,10) composé d'un dispositif d'émission et d'un dispositif de réception étant disposés dans le boîtier interne (2).

**2.** Dispositif selon la revendication 1, caractérisé en ce que le boîtier interne (2) présente un matériau électriquement conducteur et est relié au potentiel de la terre.

3. Dispositif selon la revendication 1 ou la revendication 2, caractérisé en ce que, dans le boîtier interne (2) est prévu un capteur de température et en ce qu'un circuit de régulation contrôle le produit réfrigérant de façon à ce qu'une température prédéfinie règne dans le boîtier interne (2).

4. Dispositif selon l'une des revendications 1 à 3, caractérisé en ce que la fixation (4) du substrat de mesure (5) est conçue, au niveau d'une ou de ses deux extrémités, en tant que logement à clavettes (6) disposé des deux côtés du substrat, le logement à clavettes relié directement au boîtier externe étant fixe et le logement à clavettes dirigé vers la face de la couche étant mobile par ressort.

5. Dispositif selon l'une des revendications 1 à 4, caractérisé en ce que le dispositif de mesure d'espacement présente au moins une source laser (9) et un dispositif de réception du rayonnement (10), le rayon laser émis par la source laser (9) étant dirigé sur l'arrière du substrat de mesure (5) et le rayonnement réfléchi étant reçu par le dispositif de réception (10).

6. Dispositif selon l'une des revendications 1 à 5, caractérisé en ce que le dispositif de mesure d'espacement est conçu en tant que dispositif de mesure par triangulation ou en tant qu'interféromètre.

7. Dispositif selon l'une des revendications 1 à 6, caractérisé en ce que le dispositif de mesure de la température est conçu en tant que thermodétecteur (11) disposé contre ou à proximité immédiate du substrat de mesure (5) ou en tant que pyromètre, qui est logé dans le boîtier interne (2).

8. Dispositif selon l'une des revendications 1 à 7, caractérisé en ce que les conduites électriques reliées aux éléments de conception électriques dans le boîtier interne (2), les conduites du produit réfrigérant et le cas échéant les fibres optiques, qui sont utilisées pour le dispositif de mesure de la température et/ou d'espacement, sont introduites dans la paroi du boîtier interne par au moins une canalisation d'amenée étanche au vide.

9. Dispositif selon la revendication 8, caractérisé en ce que la canalisation d'amenée (12) est conçue en tant que conduite orientable.

10. Dispositif selon l'une des revendications 1 à 9, caractérisé en ce que le substrat de mesure de contrainte (5) est disposé sur un dispositif enrouleur prévu dans le boîtier externe (1).

11. Dispositif selon l'une des revendications 1 à 10, caractérisé en ce qu'il est prévu un dispositif permettant de déterminer l'épaisseur de couche, tel qu'un moniteur de rapport.

12. Dispositif selon l'une des revendications 1 à 11, caractérisé en ce que le boîtier interne (2) est équipé d'un blindage (14) qui entoure celui-ci avec un faible espacement.

13. Dispositif selon l'une des revendications 1 à 12, caractérisé en ce qu'il est prévu contre le boîtier au moins des deux côtés du substrat de mesure (5) respectivement un dispositif permettant de mesurer le courant ionique.

14. Dispositif selon l'une des revendications 1 à 4 ou 7 à 13, caractérisé en ce que le dispositif de mesure d'espacement est conçu en tant que dispositif de mesure de déplacement capacitif ou inductif.

Fig.1